# EUROPÄISCHE PATENTANMELDUNG

(11) **EP 1 879 435 A2**
(43) Veröffentlichungstag der Anmeldung: **16.01.2008**
(21) Anmeldenummer: 07012670.1
(22) Anmeldetag: 28.06.2007
(51) Int. Cl.: H05K 3/12

(54) **Elektrisch leitfähige Strukturen**

(30) Priorität: 14.07.2006 DE 102006033055
(71) Anmelder: MAN Roland Druckmaschinen AG, 63075 Offenbach (DE)
(72) Erfinder: Baumann, Reinhard, Prof. Dr., 82152 Krailling (DE); Walther, Thomas, 63067 Offenbach (DE)
(74) Vertreter: Stahl, Dietmar

(57) **Zusammenfassung**

Die Erfindung beschreibt ein Verfahren und Vorrichtungen zum vereinfachten Herstellen elektrisch leitfähiger Strukturen auf Bedruckstoffen und Leiterplattenmaterialien. Hierzu werden Möglichkeiten in Druckprozessen und deren Anwendungen beschrieben.

## Beschreibung

Die Erfindung betrifft ein Verfahren und Vorrichtungen zur Herstellung gedruckter Leiterbahnen nach den Ansprüchen 1 und 15.

Das industriell gebräuchlichste Herstellungsverfahren von Leiterbahnen ist das Ätzverfahren. Im Ätzverfahren wird ein mit einer Kupferschicht versehenes Trägermaterial mit einem Photoätzresist beschichtet, dieses dann über eine Maske oder ein Laser belichtet und dann der unbelichtete Anteil des Photoätzresists entfernt. Anschließend erfolgt ein Ätzvorgang an denen alle Stellen, die nicht durch den Resist geschützt sind, entfernt werden. Der Nachteil dieses Verfahrens ist es, dass es sehr langsam ist und außerdem negativ arbeitet. Es werden hohe Mengen von leitfähigem Material aufgetragen, die dann in einem anschließenden Arbeitsgang wieder abgetragen werden müssen.

Es ist ebenfalls aus den DE-OS 1 075 179 und der US 2 963 748 bekannt, Trägermaterialien ganzflächig mit einem Klebstoff zu beschichten, Metallpulver darauf zu verstreuen und dann mit einem Stempel, dessen Stempelflächen in der Form der Leiteranordnung ausgestaltet sind, diejenigen Schichtteile, die als Leiterbahnen stehen bleiben sollen, einem solchen Druck zu unterwerfen, dass an diesen Stellen das Metallpulver kalt zusammengeschweißt wird. Der Nachteil dieses Verfahrens sind die hohen Stempelkosten. Außerdem lässt sich das überschüssige, nicht kalt zusammengeschweißte, Material nur schwer entfernen, da dieses in Kontakt mit dem Klebstoff steht.

Es ist weiterhin auch ein Verfahren zur Herstellung leitfähiger Strukturen aus der DE 11 47 640 bekannt, bei dem Klebstoff in Form eines Leitungsbildes auf das Trägermaterial aufgebracht wird, die anschließend mit Metallpulver bestreut wird, dessen nicht haftende Körner anschließend wieder entfernt werden. Die Körner werden unter leichtem Druck verdichtet und anschließend wird in einer chemischen Reduktionsreaktion auf der Metallpulverschicht eine Metallschicht abgelagert. Der Nachteil dieses und anderer additiver Verfahren ist, dass sie zeitaufwendig, teuer und sehr schwierig zu automatisieren sind.

Die DE 11 07 743 beschreibt ein Verfahren zur Herstellung gedruckter Schaltungen, wobei das Leitungsbild mittels des Siebdruckverfahrens auf Isolierplatten aufgedruckten Klebers gebildet wird, anschließend in einem weiteren Arbeitsschritt ein Metallpulver aufgebracht wird und dieses dann mit einer Lotschicht versehen wird, wobei zuerst eine Harzkomponente des Klebers zuerst in Form eines Leitungsbildes aufgedruckt wird und der Härter dann anschließend getrennt davon aufgebracht wird. Die aufgebrachte Metallschicht wird durch das Tauchlötverfahren verstärkt.

Die EP 0 003 363 B1 beschreibt ein Verfahren zur Herstellung leitfähiger Strukturen, wobei das Trägermaterial mit einem elektrisch isolierenden Material beschichtet ist und diese Schicht mittels bildgemäßer Beschichtung in haftende und nicht haftende Bereiche strukturiert wird. Anschließend werden Metallteilchen auf die Schicht aufgebracht, wobei die Metallteilchen auf den haftfähigen Bereichen haften und die überschüssigen Metallteilchen entfernt werden. Anschließend wird eine beschränkte Scherung auf die Metallteilchen ausgeübt, so dass diese Metallteilchen zusammengefügt werden und eine beschädigungsfreie Schaltungsspur bilden.

Die WO 2005/101930 beschreibt ein Verfahren, bei der in einem Offsetdruckwerk ein Kleber bildgemäß auf ein Träger aufgedruckt wird und das Trägermaterial dann in einem nachfolgenden Arbeitsschritt mit einer Folie in Kontakt gebracht wird, die mit einem leitfähigen Material beschichtet ist. Dieses auf der Folie befindliche leitfähige Material haftet an dem auf dem Trägermaterial bildgemäß aufgebrachten Kleber und wird von der Trägerfolie abgelöst. Das übertragene Material bildet dabei die Leiterbahn. In einer Weiterbildung wird zusätzlich ein Verfahren beschrieben, indem ein leitfähiges Material über eine Zylinder auf das Trägermaterial übertragen wird und nur an den Stellen anhaftet, die mit dem Kleber vorab bedruckt wurden. Die Trägerfolie kann auch für den Transfer isolierender Schichten genutzt werden.

Die WO 2005/086087 A1 beschreibt unter anderem den Druck von leitfähigen Antennenstrukturen in Bogenoffsetmaschinen, wobei leitfähige, gefüllte Druckfarben verwendet werden. Die Druckfarben können, unter anderen, metallische Partikel enthalten, die die Leitfähigkeit sichern sollen. Solche Art gefüllte Druckfarben weisen direkt nach dem Druck eine geringe Leitfähigkeit auf, die erst eintritt, wenn die leitfähigen Partikel in der Druckfarbe miteinander in Kontakt raten.

Es ist in vielerlei Hinsicht vorteilhaft durch Druckverfahren leitfähige Leiterbahnen auf verschiedene Substrate zu erzeugen. Druckverfahren sind positiv arbeitende Verfahren, die nur an den Stellen leitfähige Stoffe auftragen oder leitfähige Leiterbahnen erzeugen, wo diese benötigt werden. Im Gegensatz dazu wird bei dem weit verbreiteten Ätzverfahren als negativ arbeitendes Arbeitsverfahren eine Metallschicht an den Stellen durch das Ätzverfahren abgetragen, an den Stellen an denen die leitfähige Schicht nicht mehr benötigt wird. Aufgrund der zunehmenden Miniaturisierung werden die Leiterbahnen immer kleiner und enger gepackt. Dennoch werden die Ätzverfahren immer noch sehr verbreitet eingesetzt, da die Qualität und die Gleichmäßigkeit der mit den Ätzverfahren erzeugten Leiterbahnen sehr gut sind. Dennoch sind positiv arbeitende Druckverfahren, insbesondere die industriell eingesetzten Druckverfahren wie Offset-, Flexo- und Tiefdruck erneut in die Diskussion als Produktionsmittel für die Leiterplattenindustrie geraten, da die industriellen Druckverfahren einen Durchsatz an Leiterplatten erlauben, der ein Mehrfaches der einer klassischen Fertigungsstrasse ist. Auch durch die RFID (radio-frequency-identification) -Technologie und Anwendungen der Low Cost Elektronik haben leitfähige Strukturen, die in Druckverfahren aufgebracht werden an Bedeutung gewonnen. Ein Problem der gedruckten Leiterbahnen stellt dabei die Unebenheit der Strukturen dar. Diese können einerseits die Funktion, z.B. bei einer Antenne einer RFID-Lösung, beeinträchtigen. Andererseits führen die Unebenheiten zu Veränderungen der Leitungsquerschnitte und im Multilayeraufbau zu unerwünschten Veränderung der Topographie.

Aufgabe der Erfindung ist es, ein Verfahren und Vorrichtungen zum einem rationellen und sicheren Herstellen von leitfähigen Strukturen herzustellen.

Die Aufgabe wird gelöst in einem Verfahren durch die Merkmale des Anspruchs 1 und in einer Vorrichtung durch die Merkmale des Anspruchs 15

Kern des erfindungsgemäßen Verfahrens und der entsprechenden Vorrichtung ist die bildmäßige Beschichtung mit leitfähigem Material und die Nachbearbeitung der Beschichtung durch Kalandrieren und/oder Auftragen eines Reduktionsmittels.

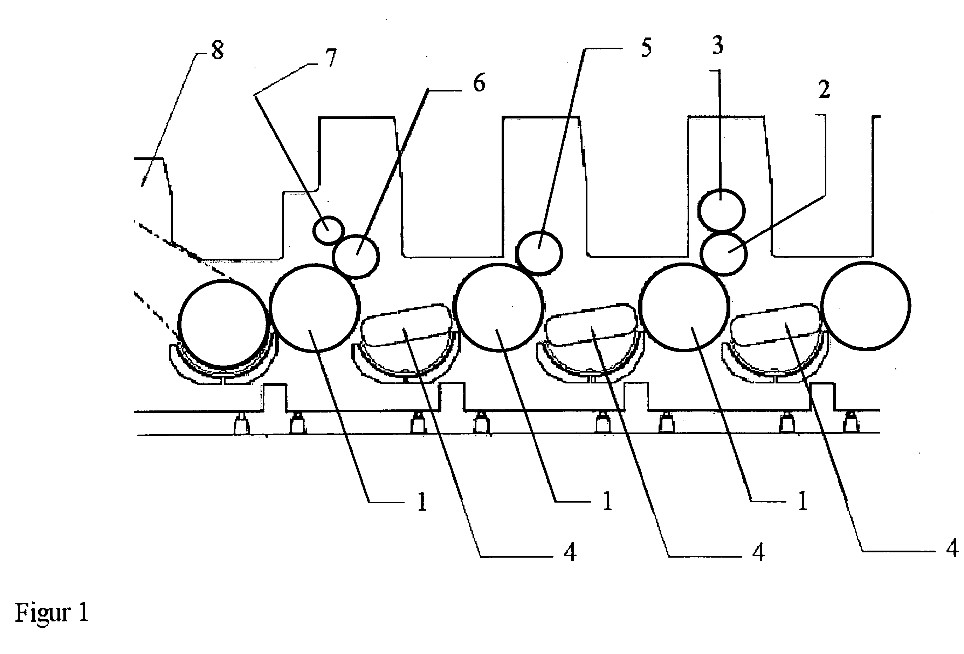

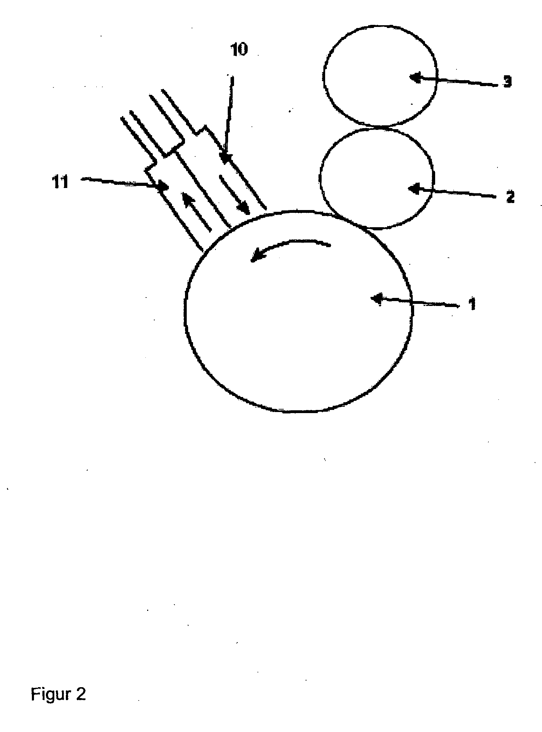

Daher ist ein erster Anspruch dieser Erfindungsmeldung, dass durch mindestens ein Druckwerk, bestehend aus einem Offset-, einem Tief-, einem Flexo- oder einem Siebdruckwerk ein Kalanderschritt erfolgt, der die gedruckte leitfähige Schicht, die eine Leiterbahn bildet, eingeebnet wird. Außerdem werden durch den Kalanderschritt die Pigmente in der Druckfarbe ausgerichtet und kommen schneller und gleichmäßiger miteinander in Kontakt
Beispielhaft ist dieser erfindungsgemäße Vorgang in Fig. 1 anhand einer Bogenoffsetdruckmaschine veranschaulicht. Eine Übertragung dieses Verfahrens auf eine Rollendruckmaschine ist jedoch für jeden Fachmann nachvollziehbar. Anstatt eines Bogens, der mittels eines Greifers durch die Druckmaschine transportiert wird, erfolgen der Druck und die anschließende Kalandrierung auf eine Rollenbahn. Die in Fig. 1 dargestellte Druckmaschine weist einen Anleger (nicht dargestellt) auf, von dem die Bogen zur Druckmaschine transportiert und dort mittels Zylinder, die Greifer aufweisen durch die Druckmaschine gefördert werden. In einem oder mehreren Druckwerk bzw. Druckwerken mit einem Gegendruckzylinder (1) und einem Gummizylinder (2) und einem Plattenzylinder (3) wird über ein Farbwerk die auf dem Plattenzylinder (3) befindliche Druckform mit einer Druckfarbe, die metallische leitfähige Partikel und / oder leitfähige Polymere und / oder Oxide von Metallen, die einem späteren Reduktionsschritt zu Metallen reduziert werden, enthält, eingefärbt und das Druckbild wird dann über das Gummituch, das sich auf dem Gummizylinder (2) befindet auf den Druckbogen, der auf dem Bogen führenden Gegendruckzylinder (1) aufliegt, übertragen. Dann wird der Druckbogen mittels eines Transferters (4) an das nächste Druckwerk oder ein Kalanderwerk übergeben. Das Kalanderwerk schließt sich dem letzten Druckwerk, das für das Drucken einer leitfähigen Druckfarbe vorgesehen ist, an und besteht aus einer Kalanderwalze (5), die mit Druck gegen den Bogen führenden Gegendruckzylinder (1) des Kalanderwerks wirkt.

Nach dem Kalandervorgang können sich ein oder mehrere Lackwerke anschließen, die einen Lackformzylinder aufweisen. Über den Lackformzylinder kann ein Dieelektrikum an den Stellen aufgetragen werden, die mechanisch und gegen Oxidation der metallischen Partikel in der Druckfarbe geschützt werden sollen. Auch dient das Dieelektrikum zur Isolierung der leitenden Schichten im Falle, dass weitere leitende Schichten aufgetragen werden sollen oder die leitende Schicht bei dem Zusammenfügen mit anderen leitenden Schichten zur Herstellung einer Multilayer-Leiterplatte in Kontakt geraten kann, ohne dass dies für die Funktion gewünscht wird.
In einer Weiterbildung weist der Kalanderzylinder (5) eine Reinigungsvorrichtung auf, die den Kalanderzylinder von eventuell anhaftenden Bestandteilen reinigen kann. Eine solche Reinigungsanlage kann eine mechanische Reinigungsvorrichtung, zum Beispiel eine Bürstenreinigungsanlage, und / oder eine nicht berührende wirkende Reinigungsanlage, wie zum Beispiel eine Ultraschallreinigungsanlage, sein.

In einer vorteilhaften Ausbildung wird über den Kalanderzylinder nicht nur Druck auf das Substrat mit den darauf befindlichen Leiterplattenbahnen ausgeübt, sondern auch ein Reduktionsmittel, zum Beispiel ein Flussmittel, übertragen. Dadurch können auf den Metallpartikeln der Druckfarbe vorhandene Oxidschichten reduziert werden oder sogar gänzlich mit Druckfarben gearbeitet werden, die Metalloxide enthalten. Das Reduktionsmittel kann auf die Kalanderoberfläche aufgesprüht oder zum Beispiel mit einer Walzenvorrichtung aufgetragen werden. Der Auftrag kann flächig oder über eine Druckform, zum Beispiel eine gravierte Form oder eine Hochdruckform erfolgen, so dass der Auftrag des Reduktionsmittels nur an den Stellen erfolgt, an denen das Reduktionsmittel benötigt wird. Sinnvoller Weise sind die Oberfläche des Kalanderzylinders (5) und des mit dem Kalanderzylinder zusammen wirkenden Gegendruckzylinders (1) in diesem Fall mit einer Schutzschicht versehen, die die Korrosion der Oberflächen durch das Reduktionsmittel verhindert oder wenigstens verzögert. Diese Schutzschicht kann eine Oberfläche aus einem passivierten Metalloxidschicht, zum Beispiel eine Chromoxid- und / oder Titanoxidoberfläche sein. Die Oberfläche kann zum Beispiel auch eine schützende Oberfläche aus einem geeigneten Polymerlackierung aufweisen, wie eine Lackierung, die Fluorpolymere und / oder Silanverbindungen enthält.

In einer erfindungsgemäßen Weiterbildung sind der Kalanderzylinder (5) und der mit dem Kalanderzylinder (5) zusammenwirkende Gegendruckzylinder (1) mit einer Platte oder Folie bespannt, die sich in einfacher Form wechseln lässt, so dass bei einer Beschädigung der Oberfläche diese ausgetauscht werden kann, ohne dass der gesamte Zylinder repariert oder schlimmstenfalls getauscht werden müsste. Für das Spannen der Platten können in bekannter Weise Spannvorrichtungen genutzt werden, wie sie heute bei Formzylindern und Gegendruckzylindern in Druckmaschinen genutzt werden.

In einer weiteren Weiterbildung wird auf das bedruckte Substrat während des Durchlaufs durch die Druckmaschine ein Reduktionsmittel aufgesprüht. Der mit dem Reduktionsmittel besprühte Bogen oder Rollenbahn kann dann in der erfindungsgemäßen Weise kalandriert werden und / oder mit einer Schutzlackierung versehen werden, die eine erneute Oxidation verhindert.

Alternativ zu dem Einsatz einer Druckfarbe, die leitfähige Metalle, leitfähige Polymere oder Metalloxide enthält, kann auch eine Klebefarbe bildgemäß auf das Trägermaterial vorgedruckt werden, die dann mit einem elektrisch leitfähigen Metallpuder oder Metalloxiden, die einem späteren Schritt mit einem Reduktionsmittel reduziert werden, bestäubt wird. Der Vorteil einer solchen Anwendung liegt darin, dass die Limitierung der Schichtdicke zum Beispiel des Offsetdrucks überwunden wird, ohne dass die hohe Auflösung des Offsetdrucks verloren geht. Für die Bestäubung kommen Metallpulver oder Metallplättchen, auch Metallflake genannt, in Frage. Geeignete Materialien sind hierzu bereits bekannt. Erfindungsgemäß sind alle Metallpulver oder Metallflakes geeignet, die es ermöglichen eine gute elektrische Leitfähigkeit entweder direkt oder nach einer Nachbehandlung (Kalandrieren und / oder Behandlung mit einem Reduktionsmittel) sicher zu stellen. Die Metallpulver oder Metallflakes können reine Metalle oder Metallverbindungen sein. Bevorzugt werden Metalle mit einer guten Oxidationsresistenz und einer guten Leitfähigkeit.

Die Bestäubung mit dem Metallpulver oder mit den Metallflakes kann über ein spezielles Aggregat erfolgen, das eine Bestäubungsvorrichtung und eine Absaugung aufweist. Das Aggregat zum Bestäuben und Absaugen des nicht benötigten Metallpuders ist dabei gegen den Gegendruckzylinder gerichtet. Ergänzend kann wie in den folgenden Figuren erläutert das Bestäubungs- und Reinigungsaggregat zusätzliche die Reinigung des Substrates von unbenötigten Partikeln unterstützende Vorrichtungen oder Kombinationen dieser Vorrichtungen aufweisen.

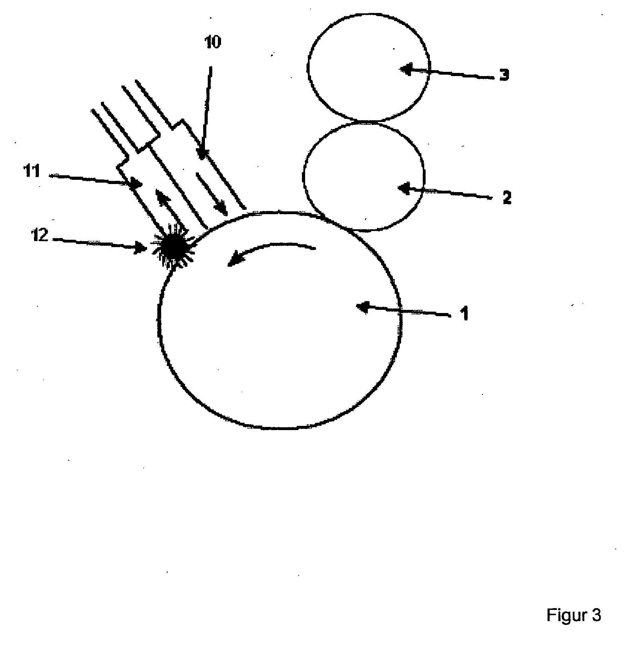

In Figur 3 ist eine einfache Ausführung einer Bestäubungs- und Absaugeinrichtung dargestellt, die gegen den Gegendruckzylinder (1) eines Druckwerkes mit Gummi-(2) und Plattenzylinder (3) wirkt. Durch den Zuführkanal (10) wird das Metallpuder auf den Bedruckstoff, der sich auf dem Gegendruckzylinder (1) befindet, geblasen und bleibt dort an den Stellen haften, an denen zuvor die Kleberschicht aufgedruckt wurde. Über den Absaugkanal (11), der in Förderichtung des Bedruckstoffes nach dem Zuführkanal (10) angeordnet ist, wird das überschüssige Metallpulver, das nicht an den Klebestellen anhaftet, wieder abgesaugt und entweder entsorgt oder einer erneuten Verwendung zugeführt, indem es in einem Kreislauf wieder dem Zuführkanal (10) zugeführt wird.

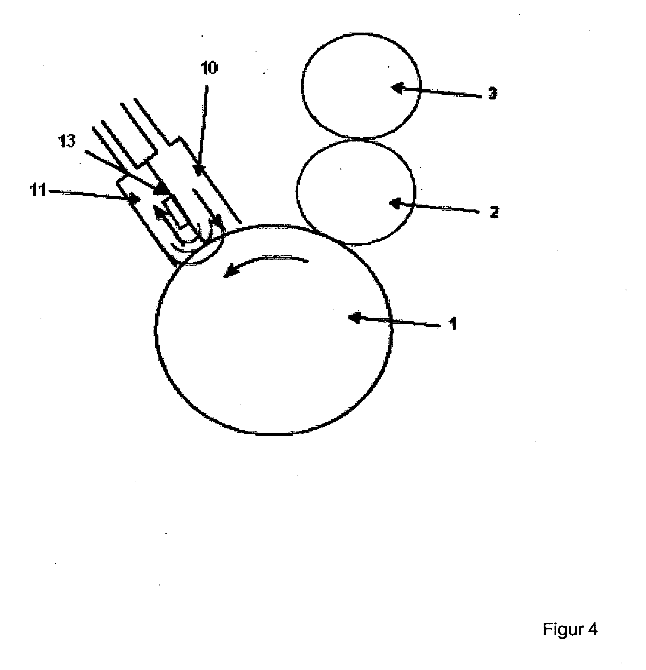

In Figur 4 wird die Reinigung des Bogens verstärkt, indem dem Absaugkanal (11) eine rotierende Bürste (12) oder rotierende Bürsten (12) zugeordnet sind, deren Drehrichtung in bevorzugter Weise gegen die Förderrichtung des Bogen gerichtet sind und das überschüssige Metallpulver immer wieder dem Absaugkanal (11) zuführen.

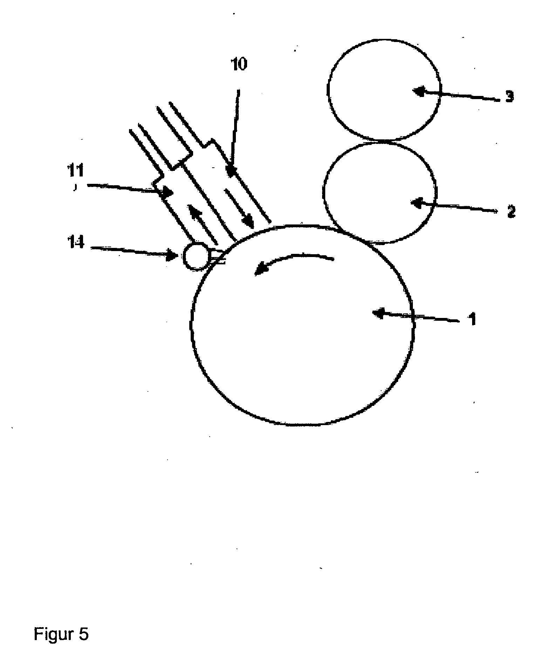

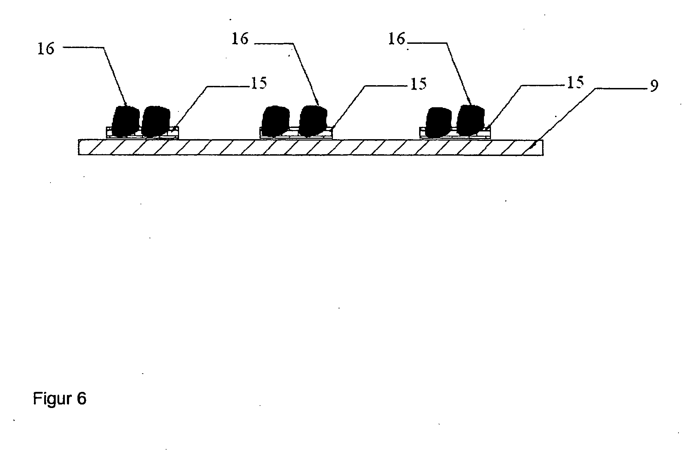

In Figur 5 ist dem Absaugkanal (11) ein Ultraschallschwinger zugeordnet, der die lose am Bedruckstoff anhaftenden Metallpartikel auflockern soll, so dass eine einfachere und gründlichere Reinigung möglich ist. In Figur 6 ist dem Absaugkanal (11) ein Blasrohr zugeordnet, dass mit Blasluft die lose auf dem Bedruckstoff anhaftenden Metallpartikel auflockert, so dass diese besser abgesaut werden können. Die Blasrichtung des Blasrohrs ist dabei in bevorzugter Weise gegen die Förderrichtung des Bedruckstoffes gewählt. Erfindungsgemäß können Zuführkanal (10) und Absaugkanal (11) in einer Vorrichtung kombiniert, oder als separat ausgestaltete Vorrichtungen vorliegen. Auch die Zusatzaggregate rotierende Bürste (12), Ultraschallschwinger (13) und Blasrohr (14) können einzeln oder in geeigneter Kombination dieser Zusatzeinrichtungen Bestandteil einer Vorrichtung oder als separate Vorrichtungen vorliegen. Erfindungsgemäße können alle Vorrichtungen auch mehrmals in Förderrichtung des Bogens hintereinander angeordnet sein. Die Erfindung umfasst ebenfalls den Einsatz solcher Vorrichtungen an Rollendruckmaschinen. Dabei können die Vorrichtungen analog der Figuren 3 bis 6 gegen einen Zylinder der Rollendruckmaschine oder gegen die Rollenbahn wirken.

Erfindungsgemäß kann es sich hierbei ebenso um eine einzelnen Vorrichtungen oder eine Abfolge von Vorrichtungen handeln.

Vorteilhaft ist die Bestäubung mit Metallflakes (Metallplättchen), da diese eine große Oberfläche haben und daher schneller miteinander in Kontakt geraten. Dennoch müssen auch diese Flakes zueinander ausgerichtet werden. Metallpulver ist dagegen meist feinteiliger und steht bei einer gleichmäßigen Bestäubung in Kontakt. Dennoch ist bei der Bestäubung mit Metallpulver oder der Bestäubung mit dickeren Metallflakes (Metallplättchen) die bestäubte Metallschicht höher als die zuvor aufgedruckte Kleberschicht. Im Offsetdruck können maximal 3 µm Schichtdicke, im Flexodruck ca. 9 µm Schichtdicke und im Siebdruck bis 20 µm Schichtdicke aufgetragen werden. Die Metallpulverbestandteile oder nicht plan liegende Flakes werden oftmals über die Kleberschicht hinausragen. Eine solche Situation ist in Figur 7 dargestellt. Auf einem Bedruckstoff (9) befindet sich eine aufgedruckte partielle Kleberschicht (15), auf die ein Metallpulver aufgestäubt wurde. Die Metallpulverkörner (16) ragen dabei aus der Kleberschicht heraus. Durch eine nachfolgenden Kalandriervorgang, der in einem Druckwerk der Druckmaschine durch einen Zylinder oder einer Kalandrierwalze, in einem Kalandrierwerk, das gegen den Bogen oder die Rollenbahn wirkt oder einer separaten Kalandriermaschine erfolgt, können die Metallpulver- oder Metallflakeschichten so verdichtet werden, dass eine gute Leitfähigkeit hergestellt wird. Außerdem wird die Haftung auf dem Bedruckstoff (9) verbessert. Ein weiterer Vorteil des Kalandriervorgangs besteht auch in der Tatsache, dass durch den einwirkenden Druck eventuell ausgebildete Oxidschichten aufgebrochen und somit die elektrische Leitfähigkeit verbessert wird. Erfindungsgemäß kann vor, während und nach dem Kalandriervorgang ein Reduktionsmittel zugeführt werden. Die Leitfähigkeit ist ohne Kalandriervorgang nach einer Bestäubung mit Metallpulver oder Metallflakes für die einige Anwendungen ausreichend, so dass die Erfindung ausdrücklich auch den Anwendungsfall umfasst, dass nach dem Bestäuben mit den Metallflakes oder dem Metallpulver kein weiterer Kalandrierschritt mehr erfolgt.

Erfindungsgemäß kann der der aufgedruckte Klebstoff selber elektrisch leitfähig sein, indem er zum Beispiel Silberpartikel enthält. Diese elektrisch leitfähigen Partikel können nach dem Bestäuben als eine Art Leitungsbrücke zwischen den aufgestäubten Metallbestandteilen dienen. In einer weiteren erfindungsgemäßen Ausführung enthält der aufgedruckte Klebstoff elektrisch leitfähige Polymere. Auch diese können als Leitungsbrücke zwischen den aufgestäubten Metallpartikeln dienen. Die Erfindung umfasst aber auch den Fall, dass der aufgedruckte Klebstoff keine oder nur eine geringe elektrische Leitfähigkeit aufweist.

In einer weiteren erfindungsgemäßen Ausführung wird die Verbindung der aufgestäubten Metallpartikel durch Löten verbessert, indem der Bedruckstoff mit der Kleberschicht und den darauf befindlichen Metallpartikeln erst einer Behandlung mit einem Flussmittel unterzogen und anschließend einer Lötvorrichtung zugeführt wird. Die Lötvorrichtung kann zum Beispiel ein Tauchlotbad oder eine Schwalllötvorrichtung.
Durch Löten wird eine nicht lösbare, stoffschlüssige und elektrisch leitende Verbindung hergestellt. Als Verbindungsmaterial dient eine schmelzbare Metalllegierung, das Lot (Metall). Mit dessen Hilfe wird eine metallische Verbindung von zwei metallischen Bauteilen erzeugt. Beim Tauchlöten wird das Werkstück ganz oder teilweise in das flüssige Lot eingetaucht, um die Lötstelle intensiv zu erhitzen. Die Lötseite der Leiterplatte wird zunächst mit einem Flussmittel benetzt. Dies kann durch aufsprühen (Sprayfluxen) oder aufschäumen (Schaumfluxen) geschehen. Danach wird die Leiterplatte mittels Konvektionsheizung oder Infrarot-Strahlern vorgeheizt. Dies geschieht zum einen um den Lösungsmittelanteil des Flussmittels zu verdampfen, da sich sonst eine Blasenbildung beim Lötvorgang ergibt, und um einen Temperaturverzug der Baugruppe durch einen zu steilen Temperaturanstieg beim nachfolgenden löten zu vermeiden. Beim Schwalllöten oder Wellenlöten wird das Lötmittel über eine Lotwelle übertragen. Die Lotwelle wird durch Pumpen von flüssigem Lot durch einen Spalt erzeugt.

Die Verbindung der auf den gedruckten Kleber aufgestäubten Metallpartikel durch Löten kann erfindungsgemäß vor oder nach dem Bestücken mit den elektronischen Bauteilen, wie z.B. Widerstände, Kondensatoren, IC etc., geschehen. Mit den erfindungsgemäßen Verfahren können flexible, halbstarre und starre Leiterplatten hergestellt werden. Diese können in einem weiteren Arbeitsschritt zu einer mehrlagigen Mehrschichtleiterplatte unter Einsatz von Prepregs verbunden werden. Ebenso können mit den erfindungsgemäßen Verfahren Antennen für RFID-Anwendungen hergestellt werden.

### Bezugszeichenliste

- 1: Gegendruckzylinder
- 2: Gummituch- / Formzylinder
- 3: Plattenzylinder
- 4: Transferter / Transferzylinder
- 5: Kalandrierzylinder / Presszylinder
- 6: Formzylinder Lackwerk
- 7: Anilox-Einfärbeeinrichtung
- 8: Ausleger
- 9: Bedruckstoff / Substrat
- 10: Zuführkanal
- 11: Absaugkanal
- 12: Bürstenreinigungsvorrichtung
- 13: Ultraschallschwinger
- 14: Blasrohr

## Patentansprüche

1. Verfahren zum Herstellen leitfähiger Strukturen auf flexiblen oder festen Substraten durch strukturiertes Aufbringen von leitfähiges Material enthaltenden Beschichtungsmedien,
**dadurch gekennzeichnet,**
**dass** in einer Rotationsdruckmaschine, die wenigstens mehrere Arbeitseinheiten wie Druckwerke und/oder Lackiermodule, aufweist, in einem ersten Schritt in einer ersten Arbeitseinheit ein Abbild der leitfähigen Strukturen auf ein Substrat aufgebracht wird, wobei das Abbild aus einem leitfähiges Material enthaltenden Beschichtungsmedium besteht, und dass in einem zweiten Schritt in einer zweiten Arbeitseinheit eine Nachbehandlung zur Erhöhung der Leitfähigkeit innerhalb der die Strukturen bildenden Schichten erfolgt.

2. Verfahren zum Herstellen leitfähiger Strukturen auf flexiblen oder festen Substraten durch strukturiertes Aufbringen von leitfähiges Material enthaltenden Beschichtungsmedien,
**dadurch gekennzeichnet,**
**dass** in einer Rotationsdruckmaschine, die wenigstens mehrere Arbeitseinheiten wie Druckwerke und/oder Lackiermodule, aufweist, in einem ersten Schritt in einer ersten Arbeitseinheit ein Abbild der leitfähigen Strukturen auf ein Substrat aufgebracht wird, wobei das Abbild aus einem klebenden Beschichtungsmedium besteht, dass in einem zweiten Schritt in einer zweiten Arbeitseinheit leitfähiges Material enthaltendes Medium auf die Kleberschicht aufgebracht wird und dass in einem dritten Schritt in einer dritten Arbeitseinheit eine Nachbehandlung zur Erhöhung der Leitfähigkeit innerhalb der die Strukturen bildenden Schichten aus Kleber und leitfähigem Material erfolgt.

3. Verfahren nach Anspruch 1 oder 2,
**dadurch gekennzeichnet,**
**dass** nach dem Aufbringen des leitfähiges Material enthaltenden Mediums in der Druckmaschine in einer weiteren Arbeitseinheit ein Auftrag eines Reduktionsmittels wenigstens auf die dergestalt erzeugten Schichten erfolgt.

4. Verfahren nach Anspruch 1 oder 2,
**dadurch gekennzeichnet,**
**dass** nach dem Aufbringen der leitfähiges Material enthaltenden Medien in einer Arbeitseinheit der Druckmaschine eine Kalandrierung durch Überwalzen der Substrate in einem Walzenwerk der Druckmaschine erfolgt.

5. Verfahren nach Anspruch 4,
**dadurch gekennzeichnet,**
**dass** während dem Kalandrieren des die Strukturen aus leitfähigem Material enthaltenden Mediums tragenden Substrats in einer Arbeitseinheit der Druckmaschine in der gleichen Arbeitseinheit ein Auftrag eines Reduktionsmittels wenigstens auf die dergestalt erzeugten Schichten erfolgt.

6. Verfahren nach Anspruch 4,
**dadurch gekennzeichnet,**
**dass** nach dem Kalandrieren des die Strukturen aus leitfähigem Material enthaltenden Mediums tragenden Substrats in einer Arbeitseinheit der Druckmaschine in einer weiteren Arbeitseinheit ein Auftrag eines Reduktionsmittels wenigstens auf die dergestalt erzeugten Schichten erfolgt.

7. Verfahren nach Anspruch 1 und 3 bis 6,
**dadurch gekennzeichnet,**
**dass** das leitfähiges Material enthaltende Medium eine Druckfarbe mit metallischen Beimischungen ist.

8. Verfahren nach Anspruch 2 bis 6,
**dadurch gekennzeichnet,**
**dass** Drucken das leitfähiges Material enthaltende Medium ein Metallpulver, ein Metalloxidpulver oder ein Medium aus Metallflakes ist, das mittels eines Klebers durch Bestäuben auf das Substrat aufgebracht wird.

9. Verfahren nach Anspruch 2 bis 6,
**dadurch gekennzeichnet,**
**dass** Drucken das leitfähiges Material enthaltende Medium ein Metallpulver, ein Metalloxidpulver oder ein Medium aus Metallflakes ist, das mittels eines leitfähigen Klebers durch Bestäuben auf das Substrat aufgebracht wird.

10. Verfahren nach Anspruch 3, 5 oder 6,
**dadurch gekennzeichnet,**
**dass** in der dem Übertrag von Reduktionsmittel dienenden Arbeitseinheit Vorkehrungen zum Schutz der an der Reduktionsmittelübertragung beteiligen Elemente vorgenommen werden.

11. Verfahren nach Anspruch 1 bis 11,
**dadurch gekennzeichnet,**
**dass** das die Leitfähigkeit des in den leitfähigen Strukturen enthaltenen leitfähigen Materials nachträglich mittels eines Lötvorganges erhöht wird.

12. Verfahren nach Anspruch 12,
**dadurch gekennzeichnet,**
**dass** vor dem Lötvorgang eine Benetzung der leitfähigen Strukturen mittels eines Flussmittels durch Sprayfluxen oder Schaumfluxen erfolgt.

13. Verfahren nach Anspruch 11 oder 12,
**dadurch gekennzeichnet,**
**dass** der Lötvorgang nach dem Verfahren des Schwalllötens oder des Wellenlötens erfolgt.

14. Verfahren nach Anspruch 11 bis 13,
**dadurch gekennzeichnet,**
**dass** der Lötvorgang vor oder nach einem Applikationsvorgang elektronischer Bauelemente auf dem Substrat erfolgt.

15. Vorrichtung zu Ausführung des Verfahrens nach Anspruch 1 oder 2 zum Herstellen leitfähiger Strukturen auf flexiblen oder festen Substraten durch strukturiertes Aufbringen von leitfähiges Material enthaltenden Beschichtungsmedien,
**dadurch gekennzeichnet,**
**dass** zur Aufbringung der Strukturen aus leitfähiges Material enthaltenden Medien eine Druckmaschine vorgesehen ist, die mehrere Arbeitseinheiten aus Bogen führenden Zylindern und diesen zugeordneten Arbeitszylindern enthält, wobei hierin wenigstens ein Druckwerk und ein oder mehrere Weiterverarbeitungswerke vorgesehen sind.

16. Vorrichtung nach Anspruch 15,
**dadurch gekennzeichnet,**
**dass** eine Weiterverarbeitungseinheit einen Kalanderzylinder zur pressenden Überrollung von beschichtetem Substrat aufweist.

17. Vorrichtung nach Anspruch 15 oder 16,
**dadurch gekennzeichnet,**
**dass** dem Kalanderzylinder eine Reinigungseinrichtung zugeordnet ist.

18. Vorrichtung nach Anspruch 15 oder 16,
**dadurch gekennzeichnet,**
**dass** dem Kalanderzylinder eine Auftrageinrichtung für Reduktionsmittel zugeordnet ist.

19. Vorrichtung nach Anspruch 17,
**dadurch gekennzeichnet,**
**dass** der Kalanderzylinder als Schutzreinrichtung eine abnehmbare Abdeckung gegen die Einwirkung von Reduktionsmittel auf dessen Oberfläche aufweist.

20. Vorrichtung nach Anspruch 15,
**dadurch gekennzeichnet,**
**dass** die Druckmaschine eine Arbeitseinheit zum Auftragen eines Kleberbildes aufweist und dass eine darauf folgende Weiterverarbeitungseinheit eine Einrichtung zum Bestäuben mit einem leitfähiges Material enthaltenden Medium aufweist.

21. Vorrichtung nach Anspruch 20,
**dadurch gekennzeichnet,**
**dass** die Einrichtung zum Bestäuben eine Mediumzuführung, einen der Oberfläche eines das Substrat führenden Zylinders zugewandten Zufuhrkanal und einen parallel zu diesem angeordneten Rücksaugkanal aufweist.

22. Vorrichtung nach Anspruch 21,
**dadurch gekennzeichnet,**
**dass** die Einrichtung zum Bestäuben eine Einrichtung zum Entfernen überschüssigen Mediums in Verbindung mit dem Rücksaugkanal aufweist, die als Bürste, Blaseinrichtung oder Ultraschallschwinger ausgebildet ist.

23. Vorrichtung nach Anspruch 15 bis 22,
**dadurch gekennzeichnet,**
**dass** der Arbeitseinheit für das Bestäuben eine Arbeitseinheit für das Kalandrieren und/oder eine Arbeitseinheit zum Aufbringen eines Reduktionsmittels oder eine Kombination dieser beiden nachgeordnet ist.
